**Europäisches Patentamt**

**European Patent Office**

**Office européen des brevets**

(11) Veröffentlichungsnummer: **0 132 551**

**A1**

## (12) EUROPÄISCHE PATENTANMELDUNG

(21) Anmeldenummer: **84106382.9**

(22) Anmeldetag: **05.06.84**

(51) Int. Cl.⁴: **H 03 K 17/945**
**H 03 K 17/78**

(30) Priorität: **29.07.83 DE 3327328**

(43) Veröffentlichungstag der Anmeldung:
**13.02.85 Patentblatt 85/7**

(84) Benannte Vertragsstaaten:
**AT BE CH DE FR GB IT LI LU NL SE**

(71) Anmelder: **i f m electronic gmbh**
**Teichstrasse 4**
**D-4300 Essen 1(DE)**

(72) Erfinder: **Spaehn, Peter**
**Birkensteige 24**
**D-7992 Tettnang(DE)**

(74) Vertreter: **Gesthuysen, Hans Dieter, Dipl.-Ing. et al,**
**Patentanwälte Gesthuysen + von Rohr Huyssenallee 15**
**Postfach 10 13 33**
**D-4300 Essen 1(DE)**

(54) **Elektronisches, berührungslos arbeitendes Schaltgerät.**

(57) Dargestellt und beschrieben ist ein elektronisches, berührungslos arbeitendes Schaltgerät, mit einem von außen beeinflußbaren Anwesenheitsindikator (10) und mit einem von dem Anwesenheitsindikator (10) - über einen Schaltverstärker (11) - steuerbaren elektronischen Schalter, wobei der Anwesenheitsindikator (10) einen Lichtsender (14) und einen Lichtempfänger (15) aufweist.

Bei einfachem Aufbau ist ein auf Dauer funktionstüchtiges und fremdlichtunempfindliches Schaltgerät dadurch realisiert, daß ein Oszillator (16) vorgesehen ist, der Lichtsender (14) synchron zu einer periodischen Oszillatorgröße, z.B. zu Oszillatorschwingungen, Lichtimpulse abgibt und der Lichtempfänger (15) im Sinne einer Gegenkopplung oder einer Mitkopplung mit dem Eingang (17) des Oszillators (16) verbunden ist.

Die Erfindung betrifft ein elektronisches, berührungslos arbeitendes Schaltgerät, mit einem von außen beeinflußbaren Anwesenheitsindikator und mit einem
von dem Anwesenheitsindikator - ggf. über einen Schaltverstärker - steuerbaren
elektronischen Schalter, z. B. einem Transistor, einem Thyristor oder einem
Triac, wobei der Anwesenheitsindikator einen Lichtsender und einen Lichtempfänger aufweist.

Elektronische Schaltgeräte der hier grundsätzlich in Rede stehenden Art sind
kontaktlos ausgeführt und werden in zunehmendem Maße anstelle von elektrischen,
mechanisch betätigten Schaltgeräten, die kontaktbehaftet ausgeführt sind, in
elektrischen Meß-, Steuer- und Regelkreisen verwendet. Das gilt insbesondere
für sogenannte Annäherungsschalter, d. h. für elektronische Schaltgeräte, die
berührungslos arbeiten. Mit solchen Annäherungsschaltern wird indiziert, ob
sich ein Beeinflussungselement, für das der entsprechende Annäherungsschalter
sensitiv ist, dem Annäherungsschalter hinreichend weit genähert hat. Hat sich
nämlich ein Beeinflussungselement, für das der entsprechende Annäherungsschalter
sensitiv ist, dem Anwesenheitsindikator hinreichend weit genähert, so steuert
der Anwesenheitsindikator den elektronischen Schalter um, d. h. bei einem
als Schließer ausgeführten Schaltgerät wird der bisher nichtleitende elektronische Schalter nunmehr leitend, während bei einem als Öffner ausgeführten
Schaltgerät der bisher leitende elektronische Schalter nunmehr sperrt. (Mit
Schaltgeräten der in Rede stehenden Art kann auch indiziert werden, ob eine
physikalische Größe eines Beeinflussungsmediums, für die das Schaltgerät sensitiv ist, einen entsprechenden Wert erreicht hat.)

Wesentlicher Bestandteil von elektronischen Schaltgeräten der zuvor grundsätzlich beschriebenen Art ist also u. a. der von außen beeinflußbare Anwesenheitsindikator. Als Anwesenheitsindikator kann z. B. ein induktiv oder kapazitiv beeinflußbarer Oszillator vorgesehen sein; es handelt sich dann um induktive oder kapazitive Annäherungsschalter (vgl. z. B. die deutschen Offen-

- 1 -

legungsschriften bzw. Auslegeschriften bzw. Patentschriften 19 51 137,
19 66 178, 19 66 213, 20 36 840m 21 27 956, 22 03 038, 22 03 039, 22 03 040,
22 03 906, 23 30 233, 23 31 732, 23 56 490, 26 13 423, 26 16 265, 26 16 733,
26 28 427, 27 11 877 und 27 44 785). Als Anwesenheitsindikator kann auch ein
Fotowiderstand, eine Fotodiode oder ein Fototransistor vorgesehen sein; es
handelt sich dann um optoelektronische Annäherungsschalter (vgl. z. B. die
deutsche Offenlegungsschrift 28 24 582).

Optoelektronische Annäherungsschalter weisen einen Lichtsender und einen
Lichtempfänger auf und werden auch als Lichtschranken bezeichnet. Dabei unterscheidet man zwischen einem Lichtschrankentyp, bei dem der Lichtsender und
der Lichtempfänger auf entgegengesetzten Seiten einer Überwachungsstrecke
angeordnet sind, und einem Lichtschrankentyp, bei dem der Lichtsender und der
Lichtempfänger am gleichen Ende einer Überwachungsstrecke angeordnet sind,
während ein am anderen Ende der Überwachungsstrecke angeordneter Reflektor
den vom Lichtsender ausgehenden Lichtstrahl zum Lichtempfänger zurückreflektiert. In beiden Fällen spricht der Anwesenheitsindikator an, wenn der normalerweise vom Lichtsender zum Lichtempfänger gelangende Lichtstrahl durch ein
in die Überwachungsstrecke gelangtes Beeinflussungselement unterbrochen wird.
Es gibt jedoch auch Lichtschranken des zuletzt beschriebenen Lichtschrankentyps, bei dem der vom Lichtsender kommende Lichtstrahl nur durch ein entsprechendes Beeinflussungselement zum Lichtempfänger zurückreflektiert wird.

Elektronische, berührungslos arbeitende Schaltgeräte sind anfangs mit einer
Reihe von Problemen behaftet gewesen, - gemessen an elektrischen, mechanisch
betätigten Schaltgeräten -, nämlich u. a. mit den Problemen "Erzeugung einer
Speisespannung für den Oszillator", "Ausbildung des Oszillators", "Einschaltimpulsverhinderung", "Kurzschlußfestigkeit". Mit diesen Problemen und deren
Lösungen (und mit anderen, bei elektronischen, berührungslos arbeitenden Schaltgeräten relevanten Problemen und deren Lösungen) befassen sich z. B. die

- 2 -

deutschen Offenlegungsschriften bzw. Auslegeschriften bzw. Patentschriften
19 51 137, 19 66 178, 16 66 213, 20 36 840. 21 27 956, 22 03 038, 22 03 039,
22 03 040, 22 03 906, 23 30 233, 23 31 732, 23 56 490, 26 13 423, 26 16 265,
26 16 773, 26 28 427, 27 11 877, 27 44 785, 29 43 911, 30 04 829, 30 38 102,
30 38 141 und 30 38 692.

Bei optoelektronischen Annäherungsschaltern, also bei elektronischen, berührungslos arbeitenden Schaltgeräten der eingangs beschriebenen Art, kann man
unterscheiden zwischen einfachen Schaltgeräten, frequenzselektiven Schaltgeräten und impulskodierten Schaltgeräten.

Bei einfachen optoelektronischen Schaltgeräten besteht der Lichtstrahl aus
Lichtimpulsen mit einer bestimmten Energie und wird die Energie des reflektierten Lichtstrahles, also die Energie der reflektierten Lichtimpulse, ausgewertet. Nachteilig ist dabei, daß bei der Auswertung dessen, was der Lichtempfänger an Licht empfängt, nicht zwischen dem reflektierten Lichtstrahl
und einem von einer Fremdlichtquelle kommenden Lichtstrahl unterschieden
werden kann.

Frequenzselektive optoelektronische Schaltgeräte sind dadurch gekennzeichnet,
daß der Lichtsender als Lichtstrahl frequenzmodulierte Lichtimpulse abgibt und
die vom Lichtempfänger aufgenommenen Lichtimpulse einen Schwingkreis anregen,
der auf die Modulationsfrequenz der vom Lichtsender abgegebenen Lichtimpulse
abgeglichen ist. Dadurch ist dieses Schaltgerät unempfindlich gegen Lichtstrahlen, die von einer Fremdlichtquelle kommen. Nachteilig ist jedoch, daß
die Resonanzfrequenz des Schwingkreises und die Modulationsfrequenz der vom
Lichtsender angegebenen Lichtimpulse im Laufe der Zeit auseinanderfallen
können, was zu einem Funktionsausfall solcher Schaltgeräte führt.

Bei impulskodierten optoelektronischen Schaltgeräten werden vom Lichtsender
als Lichtstrahl impulskodierte Lichtimpulse abgegeben und ist dem Lichtempfän-

- 3 -

ger ein Diskriminator nachgeschaltet, der nur dann anspricht, wenn der Lichtempfänger impulskodierte Lichtimpulse aufnimmt, die den vom Lichtsender abgegebenen impulskodierten Lichtimpulsen entsprechen. Auch diese Schaltgeräte
sind unempfindlich gegen Lichtstrahlen, die von einer Fremdlichtquelle kommen,
sie sind jedoch relativ aufwendig.

Der Erfindung liegt nun die Aufgabe zugrunde, ein elektronisches, berührungslos arbeitendes Schaltgerät, also einen optoelektronischen Annäherungsschalter
anzugeben, der bei einfachem Aufbau auf Dauer funktionstüchtig und fremdlichtunempfindlich ist.

Das erfindungsgemäße elektronische, berührungslos arbeitende Schaltgerät,
bei dem die zuvor aufgezeigte Aufgabe gelöst ist, ist zunächst und im wesentlichen dadurch gekennzeichnet, daß ein Oszillator vorgesehen ist, der Lichtsender synchron zu einer periodischen Oszillatorgröße, z. B. zu Oszillatorschwingungen, Lichtimpulse abgibt und der Lichtempfänger im Sinne einer Gegenkopplung oder einer Mitkopplung mit dem Eingang des Oszillators verbunden ist.

Im Sinne der zuvor zum Stand der Technik gemachten Ausführungen handelt es
sich also bei dem erfindungsgemäßen optoelektronischen Annäherungsschalter
um einen solchen, der in einfacher Weise frequenzselektiv und/oder impulskodiert ist, - frequenzselektiv, wenn man als periodische Oszillatorgröße
Oszillatorschwingungen verwendet, impulskodiert, wenn man eine impulskodierte Oszillatorgröße verwendet, also dem Ausdruck Oszillator eine besonders
weite Bedeutung beimißt. Entscheidend für das erfindungsgemäße elektronische,
berührungslos arbeitende Schaltgerät, also für den erfindungsgemäßen optoelektronischen Annäherungsschalter ist, daß ein "Weglaufen" der Oszillatorfrequenz unerheblich ist, - weil in dem Maße, in dem die Oszillatorfrequenz -
von einem Sollwert - wegläuft, die Impulsfrequenz der vom Lichtsender abgegebenen Lichtimpulse auch wegläuft, bzw. mit wegläuft.

Im einzelnen gibt es verschiedene Möglichkeiten, das erfindungsgemäße elektronische, berührungslos arbeitende Schaltgerät auszugestalten und weiterzubilden, was im folgenden nur beispielhaft erläutert werden soll.

Zuvor ist bereits dargelegt worden, daß dann, wenn erfindungsgemäß ein Oszillator vorgesehen sein soll, der Ausdruck Oszillator eine besonders weite Bedeutung haben soll. Als Oszillator soll hier nämlich jede Schaltungsanordnung verstanden sein, von der einerseits periodisch wiederkehrende Lichtimpulse - mit welcher Periodizität auch immer - abgeleitet werden können, die andererseits durch eine Gegenkopplung gedämpft bzw. durch eine Mitkopplung angefacht werden kann. Dann ist sichergestellt, daß vom Oszillator abgeleitete und vom Lichtsender abgegebene Lichtimpulse dann, wenn sie hinreichend reflektiert und vom Lichtempfänger aufgenommen werden, den Oszillator bzw. die Oszillatorschwingungen dämpfen bzw. anfachen, - was dann ohne weiteres für das Steuern des elektronischen Schalters ausgewertet werden kann.

Gibt es, wie zuvor dargelegt, eine Vielzahl von für das erfindungsgemäße elektronische, berührungslos arbeitende Schaltgerät brauchbaren Ausführungsformen von Oszillatoren, so kann es sich gleichwohl empfehlen, den Ozsillator als LC-Oszillator auszuführen, insbesondere dergestalt, daß der Oszillator einen in Emitterschaltung betriebenen Oszillatortransistor und einen Emitterwiderstand aufweist und der Lichtsender an die Verbindung von Emitter des Oszillatortransistors und Emitterwiderstand angeschlossen ist. Hierbei empfiehlt es sich dann, den Emitterwiderstand einstellbar auszuführen, so daß mit Hilfe des einstellbaren Emitterwiderstandes der Schaltabstand des erfindungsgemäßen elektronischen Schaltgerätes eingestellt werden kann.

Wenn es zuvor geheißen hat, daß bei einer Ausführungsform des erfindungsgemäßen elektronischen Schaltgerätes bei der der Oszillator einen in Emitterschaltung betriebenen Oszillatortransistor und einen Emitterwiderstand aufweist, der Lichtsender an die Verbindung von Emitter des Oszillatortransistors und Emitterwider-

- 5 -

stand angeschlossen ist, dann ist damit nicht zwingend ein direkter Anschluß des Lichtsenders an die Verbindung von Emitter des Oszillatortransistors und Emitterwiderstand gemeint. Vielmehr kann der Lichtsender über ein Anschlußnetzwerk an die Verbindung von Emitter des Oszillatortransistors und Emitterwiderstand angeschlossen sein. Ein solches Anschlußnetzwerk kann zunächst eine Schwellwertdiode aufweisen, so daß dadurch der Lichtsender in einfacher Weise Lichtimpulse abgibt.

Im übrigen ist eine bevorzugte Ausführungsform des erfindungsgemäßen elektronischen, berührungslos arbeitenden Schaltgerätes weiter dadurch gekennzeichnet, daß das Anschlußnetzwerk einen Schalttransistor aufweist und die Basis des Schalttransistors an die Verbindung von Emitter des Oszillatortransistors und Emitterwiderstand angeschlossen ist. Bei dieser Ausführungsform wird also die Leistung, die der Lichtsender benötigt, nicht über den Oszillatortransistor des Oszillators geführt, wird vielmehr die Leistung, die der Lichtsender benötigt, diesem über den Schalttransistor zugeführt und der Schalttransistor vom Potential an der Verbindung von Emitter des Oszillatortransistors und Emitterwiderstand angesteuert.

Im übrigen kann es bei der Ausführungsform des erfindungsgemäßen elektronischen Schaltgerätes, bei der der Lichtsender über ein Anschlußnetzwerk an die Verbindung von Emitter des Oszillatortransistors und Emitterwiderstand angeschlossen ist, zweckmäßig sein, das Anschlußnetzwerk mit einem Impedanzwandler zu versehen, und zwar auch dann, wenn das Anschlußnetzwerk bereits einen Schalttransistor aufweist. Der Impedanzwandler kann durch einen Hilfstransistor realisiert sein.

Wenn es weiter oben geheißen hat, daß bei dem erfindungsgemäßen elektronischen Schaltgerät der Lichtempfänger im Sinne einer Gegenkopplung oder einer Mitkopplung mit dem Eingang des Oszillators verbunden ist, dann muß es sich bei dieser Verbindung nicht um eine direkte handeln. Vielmehr kann der Lichtemp-

- 6 -

fänger über einen Eingangsverstärker und/oder über einen Ankoppelkondensator mit dem Eingang des Oszillators verbunden sein.

Im folgenden wird die Erfindung anhand einer lediglich ein Ausführungsbeispiel darstellenden Zeichnung nochmals erläutert; es zeigt

Fig. 1   das Blockschaltbild eines erfindungsgemäßen elektronischen, berührungslos arbeitenden Schaltgerätes und

Fig. 2   einen Ausschnitt aus der Schaltung des in Fig. 1 dargestellten Schaltgerätes.

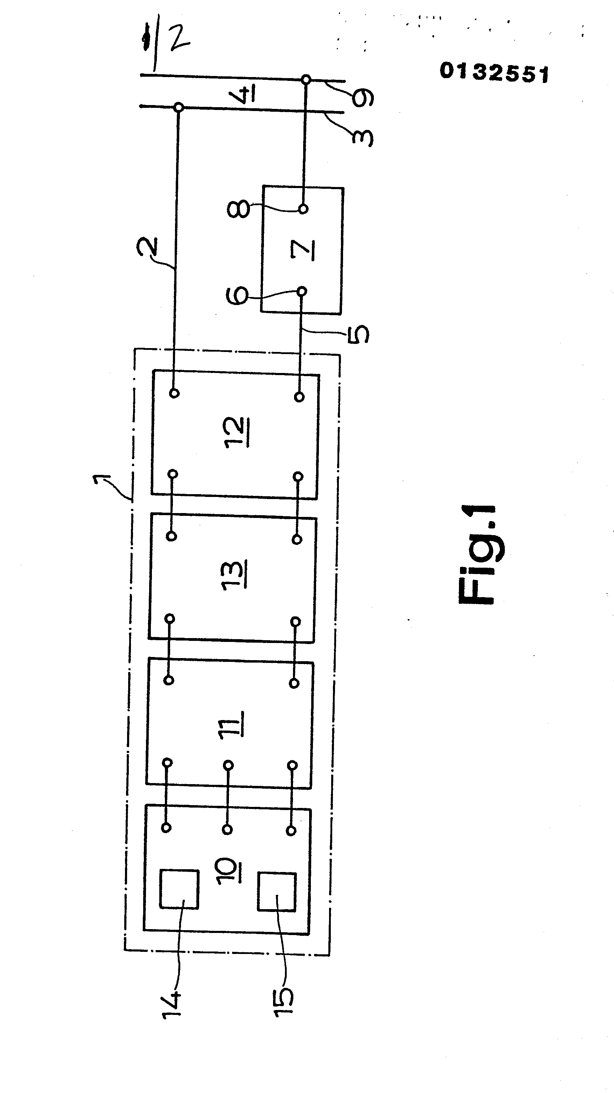

Das in Fig. 1 in Form eines Blockschaltbildes dargestellte elektronische Schaltgerät 1 arbeitet berührungslos, d. h. es spricht auf ein sich annäherndes, in den Figuren nicht dargestelltes Beeinflussungselement an und ist über einen Außenleiter 2 mit einem Pol 3 einer Spannungsquelle 4 und nur über einen weiteren Außenleiter 5 mit einem Anschluß 6 eines Verbrauchers 7 verbindbar, wobei der andere Anschluß 8 des Verbrauchers 7 an den anderen Pol 9 der Spannungsquelle 4 angeschlossen ist. Mit anderen Worten ist das dargestellte elektronische Schaltgerät 1 über insgesamt nur zwei Außenleiter 2, 5 einerseits an die Spannungsquelle 4 und andererseits an den Verbraucher 7 anschließbar.

(Die Lehre der Erfindung ist unabhängig davon, ob das Schaltgerät 1 zwei Außenleiter 2, 5 hat, wie im Ausführungsbeispiel nach Fig. 1, oder ob drei oder gar mehr als drei Außenleiter vorgesehen sind.)

In seinem grundsätzlichen Aufbau besteht das in Fig. 1 dargestellte elektronische, d. h. kontaktlose Schaltgerät 1 aus einem von außen beeinflußbaren Anwesenheitsindikator 10, aus einem dem Anwesenheitsindikator 10 nachgeschalteten Schaltverstärker 11, aus einem von dem Anwesenheitsindikator 10 über

- 7 -

**0132551**

den Schaltverstärker 11 steuerbaren elektronischen Schalter 12, z. B. einem Thyristor, und aus einer Speiseschaltung 13 zur Erzeugung der Speisespannung für den Anwesenheitsindikator 10 und den Schaltverstärker 11.

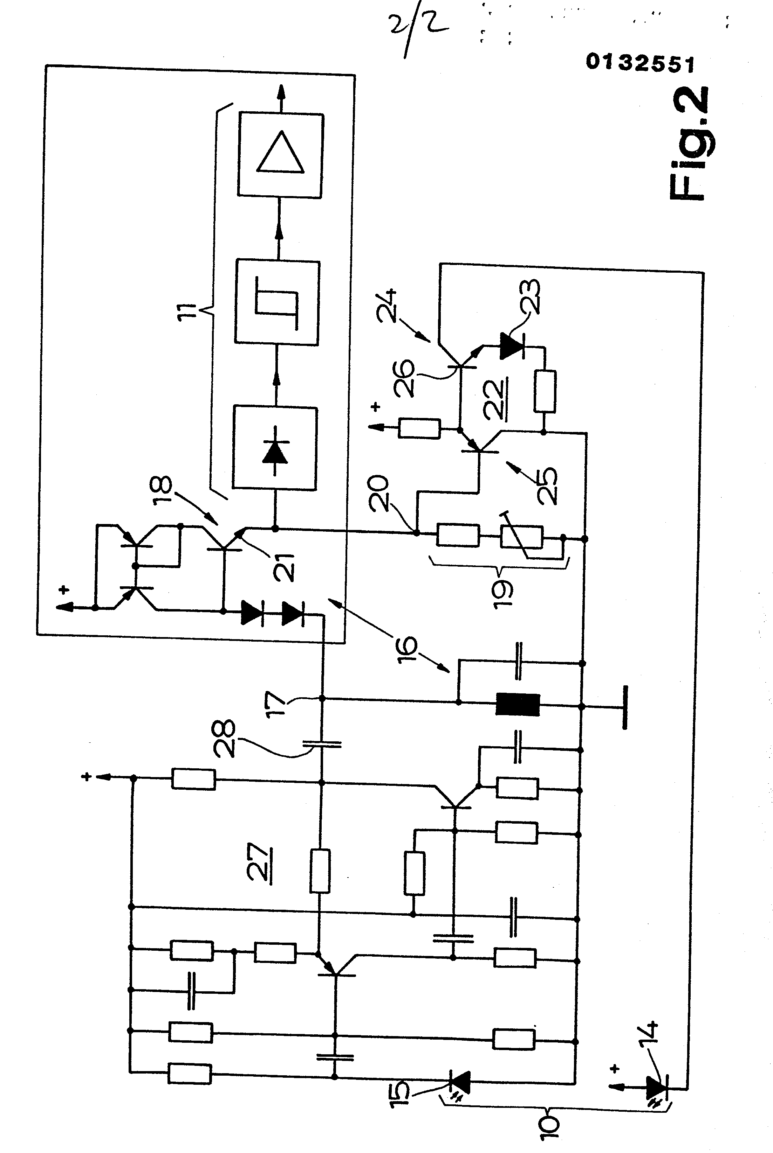

Wie in Fig. 1 nur angedeutet und in Fig. 2 detailliert dargestellt, weist bei dem erfindungsgemäßen elektronischen Schaltgerät 1 der Anwesenheitsindikator 10 einen Lichtsender 14 und einen Lichtempfänger 15 auf. Bei dem erfindungsgemäßen elektronischen, berührungslos arbeitenden Schaltgerät 1 handelt es sich also um einen optoelektronischen Annäherungsschalter.

Wie nun die Fig. 2 zeigt, ist ein Oszillator 16 vorgesehen, gibt der Lichtsender 14 synchron zu einer periodischen Oszillatorgröße, z. B. zu Oszillatorschwingungen, Lichtimpulse ab und ist der Lichtempfänger 15 im Sinne einer Gegenkopplung mit dem Eingang 17 des Oszillators 16 verbunden.

Im in Fig. 2 dargestellten Ausführungsbeispiel ist der Oszillator 16 als LC-Oszillator ausgeführt. Der Oszillator 16 weist einen in Emitterschaltung betriebenen Oszillatortransistor 18 und einen Emitterwiderstand 19 auf. Der Lichtsender 14 ist an die Verbindung 20 von Emitter 21 des Oszillatortransistors 18 und Emitterwiderstand 19 angeschlossen. Der Emitterwiderstand 19 ist einstellbar, so daß mit Hilfe des Emitterwiderstandes 19 der Schaltabstand des erfindungsgemäßen Schaltgerätes 1 eingestellt werden kann.

Im übrigen zeigt die Fig. 2 insoweit eine bevorzugte Ausführungsform des erfindungsgemäßen elektronischen Schaltgerätes 1, als der Lichtsender 14 über ein Anschlußnetzwerk 22 an die Verbindung 20 von Emitter 21 des Oszillatortransistors 18 und Emitterwiderstand 19 angeschlossen ist. Das Anschlußnetzwerk 22 weist eine Schwellwertdiode 23, einen Schalttransistor 24 und einen Impedanzwandler 25 auf. Dabei ist die Basis 26 des Schalttransistors 24 an die Verbindung 20 von Emitter 21 des Oszillatortransistors 18 und Emitterwiderstand 19 angeschlossen und der Impedanzwandler 25 durch einen Hilfstransistor realisiert.

Schließlich zeigt die Fig. 2 noch insoweit eine bevorzugte Ausführungsform des erfindungsgemäßen Schaltgerätes 1, als der Lichtempfänger 15 über einen Eingangsverstärker 27 und über einen Ankoppelkondensator 28 mit dem Eingang 17 des Oszillators 16 verbunden ist.

- 9 -

Patentansprüche:

1. Elektronisches, berührungslos arbeitendes Schaltgerät, mit einem von außen beeinflußbaren Anwesenheitsindikator und mit einem von dem Anwesenheitsindikator - ggf. über einen Schaltverstärker - steuerbaren elektronischen Schalter, z. B. einem Transistor, einem Thyristor oder einem Triac, wobei der Anwesenheitsindikator einen Lichtsender und einen Lichtempfänger aufweist, d a d u r c h g e k e n n z e i c h n e t, daß ein Oszillator(16) vorgesehen ist, der Lichtsender (14) synchron zu einer periodischen Oszillatorgröße, z. B. zu Oszillatorschwingungen, Lichtimpulse abgibt und der Lichtempfänger (15) im Sinne einer Gegenkopplung oder einer Mitkopplung mit dem Eingang (17) des Oszillators (16) verbunden ist.

2. Elektronisches Schaltgerät nach Anspruch 1, dadurch gekennzeichnet, daß der Oszillator (16) als LC-Oszillator ausgeführt ist.

3. Elektronisches Schaltgerät nach Anspruch 1 oder 2, dadurch gekennzeichnet, daß der Oszillator (16) einen in Emitterschaltung betriebenen Oszillatortransistor (18) und einen Emitterwiderstand (19) aufweist und der Lichtsender (14) an die Verbindung (20) von Emitter (21) des Oszillatortransistors (18) und Emitterwiderstand (19) angeschlossen ist.

4. Elektronisches Schaltgerät nach Anspruch 3, dadurch gekennzeichnet, daß der Emitterwiderstand (19) einstellbar ist.

5. Elektronisches Schaltgerät nach Anspruch 3 oder 4, dadurch gekennzeichnet, daß der Lichtsender (14) über ein Anschlußnetzwerk (22) an die Verbindung (20) von Emitter (21) des Oszillatortransistors (18) und Emitterwiderstand (19) angeschlossen ist.

- 1 -

6. Elektronisches Schaltgerät nach Anspruch 5, dadurch gekennzeichnet, daß das Anschlußnetzwerk (22) eine Schwellwertdiode (23) aufweist.

7. Elektronisches Schaltgerät nach Anspruch 5 oder 6, dadurch gekennzeichnet, daß das Anschlußnetzwerk (22) einen Schalttransistor (24) aufweist und die Basis (26) des Schalttransistors (24) an die Verbindung (20) von Emitter (21) des Oszillatortransistors (18) und Emitterwiderstand (19) angeschlossen ist.

8. Elektronisches Schaltgerät nach einem der Ansprüche 5 bis 7, dadurch gekennzeichnet, daß das Anschlußnetzwerk (22) einen vorzugsweise durch einen Hilfstransistor realisierten Impedanzwandler (25) aufweist.

9. Elektronisches Schaltgerät nach einem der Ansprüche 1 bis 8, dadurch gekennzeichnet, daß der Lichtempfänger (15) über einen Eingangsverstärker (27) mit dem Eingang (17) des Oszillators (16) verbunden ist.

10. Elektronisches Schaltgerät nach einem der Ansprüche 1 bis 9, dadurch gekennzeichnet, daß der Lichtempfänger (15) über einen Ankoppelkondensator (28) mit dem Eingang (17) des Oszillators (16) verbunden ist.

Fig.1

2/2

0132551

Fig.2

# Europäisches Patentamt

## EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| A | ELECTRONIC ENGINEERING, Band 55, Nr. 678, Juni 1983, LONDON, Great Britain; M.J. NOBLE: "Reliable infrared emitter/detector operation", Seite 38 * Figur (s. RC-Oszillator) --- | 1 | H 03 K 17/945 H 03 K 17/78 |
| A | DE-B-2 320 094 (HANS LINGL ANLAGENBAU UND VERFAHRENSTECHNIK KG) * Figur 3 * --- | 1 | |
| A | IBM TECHNICAL DISCLOSURE BULLETIN, Band 25, Nr. 7A, Dezember 1982; G.M. SMITH: "Light position sensor", Seiten 3307-3308 --- | | |
| A | DE-A-2 901 117 (A. BERGSTRÖM) --- | | |
| A | DE-B-1 623 778 (HARTMANN & BRAUN AG) --- | | |
| A | US-A-3 509 359 (K.H. EMBLING) ----- | | |

| | RECHERCHIERTE SACHGEBIETE (Int Cl 4) |
|---|---|
| | G 01 D 21/00 G 01 D 21/02 G 01 V 9/04 G 08 B 13/18 H 03 K 17/78 H 03 K 17/94 H 03 K 17/945 |

Der vorliegende Recherchenbericht wurde für alle Patentansprüche erstellt.

| Recherchenort | Abschlußdatum der Recherche | Prüfer |
|---|---|---|
| BERLIN | 10-07-1984 | ARENDT M |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, überein- stimmendes Dokument